# DEMANDE DE BREVET EUROPEEN

(11) **EP 1 180 789 A1**
(43) Date de publication de la demande: **20.02.2002**
(21) Numéro de dépôt: 01402040.8
(22) Date de dépôt: 27.07.2001
(51) Int. Cl.: H01L 21/02, H01L 21/768

(54) **Procédé de fabrication d'un condensateur au sein d'un circuit intégré, et circuit intégré correspondant.**

(30) Priorité: 18.08.2000 FR 0010727
(71) Demandeur: STMicroelectronics S.A., 92120 Montrouge (FR); COMMISSARIAT A L'ENERGIE ATOMIQUE, 75015 Paris (FR)
(72) Inventeur: Morand, Yves, 38000 Grenoble (FR); Pelloie, Jean-Luc, 38430 Moirans (FR)
(74) Mandataire: Casalonga, Axel

(57) **Abrégé**

La réalisation du condensateur comprend :
- la réalisation simultanée, dans au moins une partie d'une couche isolante inter-pistes 3 associée à un niveau de métallisation donné, d'une part des deux électrodes 50, 70 et de la couche diélectrique 60 du condensateur, et d'autre part d'une tranchée conductrice 41 prolongeant latéralement l'électrode inférieure du condensateur, électriquement isolée de l'électrode supérieure, et présentant une dimension transversale plus faible que la dimension transversale du condensateur, et
- la réalisation, dans la couche isolante inter-niveaux 8 recouvrant ladite couche isolante inter-pistes, de deux plots conducteurs 80, 81 venant respectivement au contact de l'électrode supérieure du condensateur et de ladite tranchée conductrice.

## Description

L'invention concerne la fabrication des circuits intégrés et plus particulièrement la réalisation des condensateurs "métal-métal".

Parmi les différents types de condensateurs pouvant figurer au sein d'un circuit intégré, sur une pastille semiconductrice, par exemple du silicium, on peut citer les capacités dites "polysilicium-silicium", ou "polysilicium-polysilicium", ou encore "métal-métal", en fonction de la composition de leurs électrodes.

Les condensateurs dits "métal-métal", c'est-à-dire dont les deux électrodes sont métalliques, permettent de réaliser des capacités de fortes valeurs et offrent l'avantage de présenter une très faible variation de la valeur de capacité en fonction de la tension qui leur est appliquée. Elle possède en outre un élément résistif très faible. Les condensateurs "métal-métal" sont ainsi avantageusement utilisés dans les applications radiofréquence.

Un circuit intégré comprend généralement des composants électroniques, par exemple des transistors, réalisés au sein d'un substrat semiconducteur, ainsi que différents niveaux de métallisation permettant de réaliser notamment des pistes d'interconnexion entre les différents composants du circuit intégré. Chaque niveau de métallisation comporte alors généralement, après gravure d'une couche métallique, plusieurs pistes d'interconnexion situées à ce même niveau, mutuellement séparées par une couche isolante inter-pistes. Le niveau de métallisation immédiatement supérieur est alors réalisé sur une couche isolante inter-niveaux recouvrant le niveau de métallisation inférieur. L'interconnexion entre des pistes situées à deux niveaux de métallisation adjacents est réalisée par des trous d'interconnexion remplis d'un métal de remplissage, par exemple du tungstène, et communément appelé par l'homme du métier des "vias".

Un procédé connu de fabrication d'un condensateur métal-métal au sein d'un circuit intégré consiste à réaliser l'une des électrodes du condensateur en même temps que l'ensemble des pistes d'interconnexion d'un niveau de métallisation donné. Puis, on dépose sur ce niveau de métallisation donné, une couche isolante inter-niveaux destinée à supporter le niveau de métallisation immédiatement supérieur. On grave alors dans cette couche isolante inter-niveaux un orifice débouchant au-dessus de la première électrode du condensateur, puis on effectue un dépôt d'une fine couche de matériau diélectrique, par exemple généralement du dioxyde de silicium ou éventuellement du nitrure de silicium. Puis, on remplit, par dépôt puis aplanissement, ledit orifice avec du métal de remplissage, typiquement du tungstène. On dépose ensuite la couche métallique du niveau de métallisation immédiatement supérieur que l'on grave de façon à réaliser les pistes d'interconnexion de ce niveau de métallisation, ainsi que la deuxième électrode du condensateur métal-métal.

En d'autres termes, selon cette solution, on réalise les deux électrodes du condensateur métal-métal sur deux niveaux de métallisation.

D'autres solutions prévoient de réaliser les deux électrodes du condensateur métal-métal en utilisant un seul niveau conducteur.

Ainsi, dans la demande de brevet français n° 2 766 294, on réalise les deux électrodes métalliques et la couche diélectrique du condensateur quasiment sur un niveau de métallisation, l'électrode inférieure du condensateur résultant d'une gravure de la couche métallique destinée à former les différentes pistes du niveau de métallisation.

Le brevet américain n° 6 008 083 décrit une autre façon de réaliser un condensateur métal-métal, dont les deux électrodes sont réalisées au sein d'une même couche isolante inter-niveaux. Cependant, la réalisation d'un tel condensateur nécessite, préalablement à la réalisation de l'électrode inférieure, la formation d'un plot contactant cette électrode inférieure et réalisé au sein du niveau de métallisation inférieur.

L'invention vise à proposer la réalisation d'un condensateur métal-métal, en utilisant un seul niveau conducteur, mais selon un procédé totalement différent de ceux utilisés dans l'art antérieur, et ne nécessitant notamment aucune formation, préalablement à celle de la première électrode, d'un plot de contact permettant la connexion à l'électrode inférieure.

Un but de l'invention est de proposer de tels procédés de réalisation qui soient compatibles avec un procédé de type "damascène", selon une dénomination bien connue de l'homme du métier.

L'invention a encore pour but de proposer un procédé qui permette la réalisation au même niveau, d'un condensateur et d'une piste métallique appartenant à ce niveau de métallisation.

L'invention propose donc un procédé de fabrication d'un circuit intégré, comportant la réalisation de plusieurs niveaux de métallisation mutuellement séparés par des couches isolantes inter-niveaux, et de couches isolantes inter-pistes séparant chacune les pistes d'un même niveau de métallisation. Le procédé comprend également la réalisation d'au moins un condensateur comportant une électrode inférieure et une électrode supérieure, mutuellement séparées par une couche de matériau diélectrique.

Selon une caractéristique générale de l'invention, la réalisation du condensateur comprend :
- la réalisation simultanée, dans au moins une partie d'une couche isolante inter-pistes associée à un niveau de métallisation donné, d'une part des deux électrodes et de la couche diélectrique du condensateur, et d'autre part d'une tranchée conductrice prolongeant latéralement l'électrode inférieure du condensateur, électriquement isolée de l'électrode supérieure, et présentant une dimension transversale plus faible que la dimension transversale du condensateur, et
- la réalisation, dans la couche isolante inter-niveaux recouvrant ladite couche isolante inter-pistes, de deux plots conducteurs venant respectivement au contact de l'électrode supérieure du condensateur et de ladite tranchée conductrice.

En d'autres termes, l'invention prévoit, par la réalisation simultanée du condensateur et de la tranchée latérale, la prise de contact des deux électrodes du condensateur, par le haut du circuit intégré. L'invention ne nécessite donc nullement la formation, préalablement à celle du condensateur, d'un plot de contact inférieur pour la connexion de l'électrode inférieure.

Selon un mode de mise en oeuvre du procédé selon l'invention, la réalisation du condensateur et de la tranchée comporte :
a) la formation sur une couche isolante inter-niveaux, de ladite couche isolante inter-pistes,
b) la gravure d'au moins une partie de la couche isolante inter-pistes de façon à former une cavité comportant une partie principale prolongée latéralement par ladite tranchée,
c) la formation sur la structure obtenue à l'étape b) d'une première couche d'un premier matériau conducteur, par exemple du cuivre ou de l'aluminium, et la formation sur ladite première couche, d'une couche d'un matériau diélectrique, par exemple du dioxyde de silicium, et
d) la formation sur ladite couche diélectrique, d'une deuxième couche d'un deuxième matériau conducteur, par exemple également du cuivre ou de l'aluminium, de façon à remplir la partie principale de ladite cavité, les dimensions de la tranchée et les épaisseurs de ladite première couche et de ladite couche diélectrique étant choisies de façon à obtenir à l'issue de l'étape d), une tranchée comportant au moins le premier matériau conducteur et exempte du deuxième matériau conducteur (la tranchée pouvant éventuellement contenir du matériau diélectrique),
e) un polissage mécano-chimique de l'empilement de couches formées aux étapes c) et d) de façon
   à laisser subsister dans la partie principale de la cavité, ledit condensateur dont l'électrode inférieure est formée d'une partie résiduelle de la première couche tapissant les parois internes de la cavité, et dont l'électrode supérieure est formée d'une partie résiduelle de ladite deuxième couche, séparée de ladite partie résiduelle de la première couche par une partie résiduelle de la couche diélectrique, et
   à laisser subsister dans ladite tranchée une autre partie résiduelle de ladite première couche tapissant au moins les parois internes de la tranchée, à l'exclusion de toute partie résiduelle de ladite deuxième couche.

Dans l'étape c), les formations de la première couche conductrice et de la couche diélectrique peuvent être obtenues par un dépôt conforme. Dans ce cas, la largeur de la tranchée est de préférence au moins égale au double de l'épaisseur de la première couche conductrice et inférieure au double de la somme de l'épaisseur de la première couche conductrice et de l'épaisseur de la couche diélectrique.

Selon les dimensions de la tranchée, celle-ci peut ne comporter que le matériau conducteur formant la première électrode, ou éventuellement le matériau conducteur formant la première couche et une partie résiduelle du matériau diélectrique.

L'invention permet également de réaliser avantageusement les pistes dudit niveau de métallisation donné, simultanément à la formation de l'électrode supérieure du condensateur.

Ainsi, selon un mode de mise en oeuvre de l'invention, la réalisation des pistes dudit niveau de métallisation donné comporte
- après l'étape c), une gravure de la couche diélectrique, de la première couche conductrice et de la couche isolante inter-pistes, de façon à former au moins une tranchée auxiliaire (définissant l'emplacement d'une piste),
- le dépôt de ladite deuxième couche conductrice effectué à l'étape d), de façon à remplir ladite ou lesdites tranchées auxiliaires, et
- le polissage mécano-chimique effectué à l'étape e), de façon à éliminer la première couche conductrice et la couche diélectrique et la deuxième couche conductrice de la surface de la couche isolante inter-pistes.

L'invention a également pour objet un circuit intégré, comportant plusieurs niveaux de métallisation mutuellement séparés par des couches isolantes inter-niveaux, et des couches isolantes inter-pistes séparant chacune les pistes d'un même niveau de métallisation. Le circuit intégré comprend également au moins un condensateur comportant une élecrode inférieure et une électrode supérieure mutuellement séparées par une couche de matériau diélectrique.

Selon une caractéristique générale de l'invention, le condensateur est situé dans au moins une partie d'une couche isolante inter-pistes associée à un niveau de métallisation donné. L'électrode inférieure du condensateur est prolongée latéralement par une tranchée conductrice, électriquement isolée de l'électrode supérieure, et présentant une dimension transversale plus faible que la dimension transversale du condensateur. Le circuit intégré comporte également, dans la couche isolante inter-niveaux recouvrant ladite couche isolante inter-pistes, deux plots conducteurs venant respectivement au contact de l'électrode supérieure du condensateur et de ladite tranchée conductrice.

Selon un mode de réalisation du circuit intégré selon l'invention, la tranchée comporte uniquement le matériau conducteur formant ladite électrode inférieure.

Dans une autre variante de réalisation, la tranchée peut comporter uniquement le matériau diélectrique enrobé par le matériau conducteur formant ladite électrode inférieure.

Mais, dans tous les cas, la tranchée est exempte du matériau conducteur formant la deuxième électrode.

Par ailleurs, les pistes dudit niveau de métallisation donné sont formées avantageusement du même matériau que celui formant l'électrode supérieure du condensateur.

D'autres avantages et caractéristiques de l'invention apparaîtront à l'examen de la description détaillée de modes de réalisation et de mise en oeuvre, nullement limitatifs, et les dessins annexés, sur lesquels :
- les figures 1, 2, 3a à 3c, 4a à 4c, et 5 illustrent un premier mode de mise en oeuvre d'un procédé selon l'invention, aboutissant à un premier mode de réalisation d'un condensateur selon l'invention;
- les figures 6 et 7 illustrent partiellement un deuxième mode de mise en oeuvre d'un procédé selon l'invention, aboutissant à une tranchée latérale comportant également du matériau diélectrique; et
- les figures 8 à 11 illustrent une variante du procédé selon l'invention, permettant la réalisation simultanée de la deuxième électrode d'un condensateur et d'une piste du niveau de métallisation correspondant.

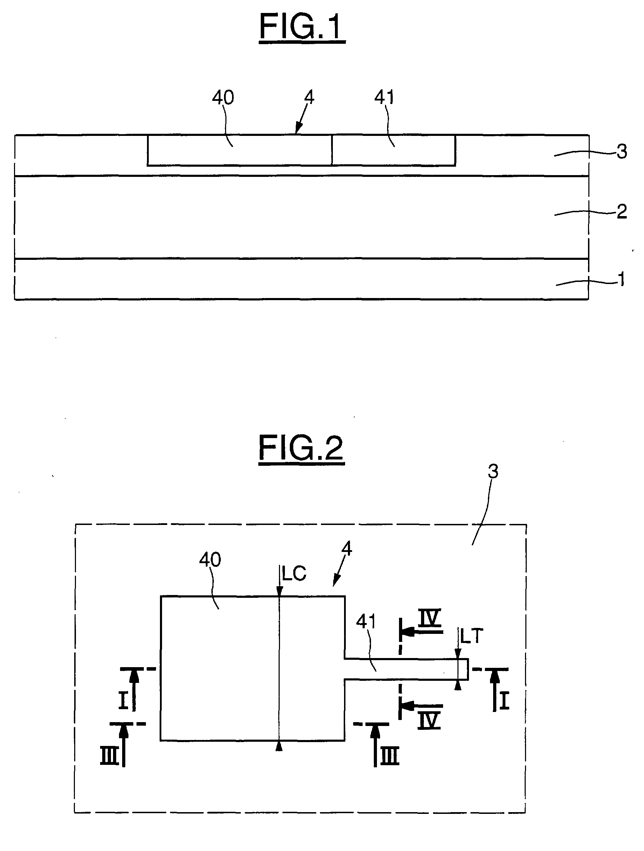

Sur la figure 1 qui est une vue selon la ligne I-I de la figure 2, la référence 1 désigne par exemple un premier niveau de métallisation comportant des pistes métalliques mutuellement isolées par une couche de diélectrique inter-pistes. En variante, la référence 1 pourrait représenter un susbstrat semiconducteur comportant par exemple des transistors.

Dans tout ce qui suit, on supposera que la référence 1 désigne par exemple le niveau de métallisation M1.

Ce niveau M1, ayant typiquement une épaisseur inférieure à 1/2 micron, est recouvert d'une couche isolante inter-niveaux 2 ayant typiquement une épaisseur comprise entre 1/2 micron et 1 micron.

On dépose ensuite sur la couche diélectrique inter-niveaux 2, une couche diélectrique 3 destinée à former le diélectrique inter-pistes des pistes métalliques du niveau de métallisation immédiatement supérieur, à savoir le niveau de métallisation M2.

On grave ensuite une partie de la couche isolante inter-pistes 3 de façon à former une cavité 4, illustrée en vue de dessus sur la figure 2, et comportant une partie principale 40 prolongée latéralement par une tranchée 41.

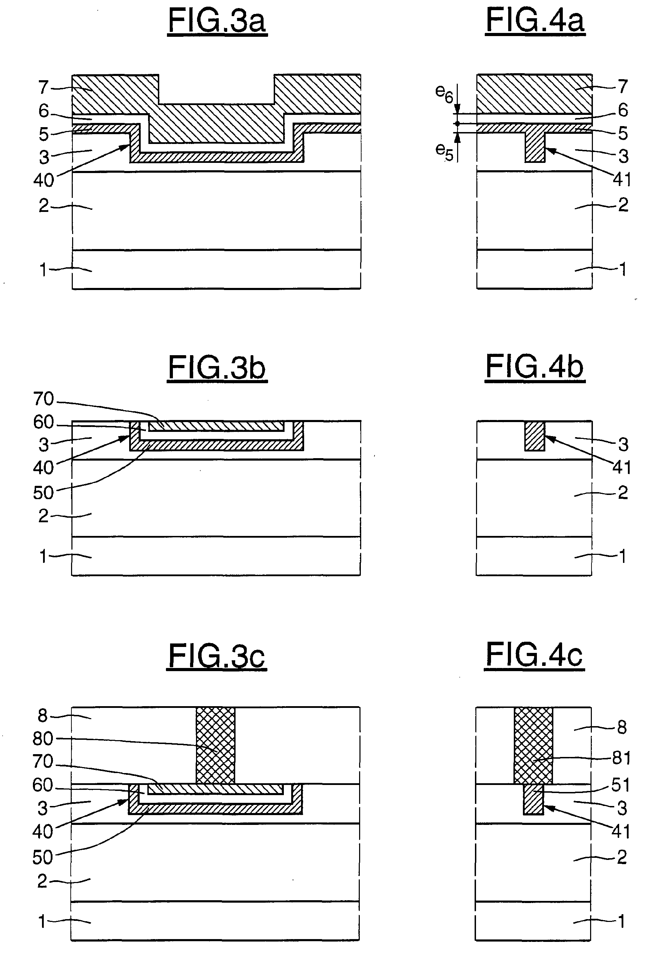

Sur la figure 3, la profondeur de la cavité 4 est inférieure à l'épaisseur de la couche 3. Ceci étant, cette profondeur pourrait être égale à l'épaisseur de la couche 3, et voire supérieure, la cavité s'étendant alors partiellement dans la couche isolante sous-jacente 2.

Bien entendu, l'homme du métier saura ajuster les paramètres de la gravure de façon à ce que la profondeur de la cavité 4 ne soit pas trop importante de façon à éviter notamment de déboucher sur le niveau de métallisation inférieur M1.

La dimension transversale LT, ou largeur de la tranchée 4 lest ici plus faible que la dimension transversale LC de la partie principale 40 de la cavité 4. On reviendra plus en détail ci-après sur le choix de la valeur de la dimension latérale LT de la tranchée.

Dans la suite de la description, les figures 3a à 3c illustrent les structures vues selon la ligne III-III de la figure 2, tandis que les figures 4a à 4c illustrent les mêmes structures vues selon la ligne IV-IV de la figure 2.

On dépose sur la structure illustrée sur les figures 1 et 2, une première couche 5 d'un premier matériau conducteur (figures 3a et 4a). Ce premier matériau conducteur qui sera destiné à former le matériau de la première électrode du condensateur, est un métal tel que par exemple de l'aluminium, du titane, du nitrure de titane, du nitrure de tantale, ...

L'épaisseur e₅ de cette première couche 5 est typiquement de l'ordre de 0,1 micron, et la première couche est formée par exemple par un dépôt conforme chimique en phase vapeur (dépôt CVD).

On forme alors, sur la première couche 5, une couche 6 d'un matériau diélectrique, également par exemple par un dépôt CVD. Cette couche de matériau diélectrique peut être formée par exemple de dioxyde de silicium, de nitrure de silicium ou de tout matériau à haute constante diélectrique. L'épaisseur e₆ de cette couche 6 est par exemple de l'ordre de 0,1 micron.

On recouvre ensuite la couche de diélectrique 6 par une deuxième couche 7 formée d'un deuxième matériau conducteur, qui peut être analogue ou bien différent du premier matériau conducteur formant la couche 5.

L'épaisseur de cette couche 7, qui est également formée par exemple par un dépôt CVD, est choisie de façon à remplir la partie principale 40 de la cavité.

D'une façon générale, les dimensions de la tranchée, et notamment la dimension latérale LT, ainsi que les épaisseurs de la première couche 5 et de la couche diélectrique 6, sont choisies de façon à obtenir après le dépôt des couches 5, 6 et 7, une tranchée comportant le premier matériau conducteur 5 et éventuellement le matériau diélectrique, mais ne comportant en aucun cas le deuxième matériau conducteur 7.

Ainsi, lorsque les couches sont obtenues par un dépôt conforme, la largeur LT de la tranchée sera choisie inférieure au double de la somme e₅ + e₆ de l'épaisseur de la première couche 5 et de l'épaisseur de la couche diélectrique 6.

Sur l'exemple illustré sur la figure 4a, on a supposé que la largeur LT était telle que la tranchée 41 était uniquement remplie du premier matériau conducteur 5.

On effectue ensuite (figures 3b et 4b) un polissage mécano-chimique de la structure illustrée sur les figures 3a et 4a, de façon à éliminer la deuxième couche conductrice, la couche diélectrique et la première couche conductrice de la surface de la couche isolante inter-pistes 3.

Ainsi, à ce stade, la partie principale de la cavité 40 est tapissée d'une partie résiduelle 50 de la couche 5, recouverte d'une partie résiduelle 60 de la couche diélectrique, elle-même recouverte d'une partie résiduelle 70 de la deuxième couche conductrice 7. De même, la tranchée latérale 41 est remplie d'une autre partie résiduelle 51 de la première couche conductrice 5.

La partie résiduelle 50 va ainsi former l'électrode inférieure du condensateur tandis que la partie résiduelle 70 va former l'électrode supérieure, les deux électrodes étant séparées par un diélecrique 60.

On dépose ensuite, de façon classique et connue en soi (figures 3c et 4c), la couche isolante inter-pistes 8 destinée à isoler mutuellement les pistes du niveau de métallisation M2.

Puis, on grave localement cette couche isolante inter-pistes 8 de façon à former deux cavités débouchant respectivement au-dessus de l'électrode supérieure 70 du condensateur et au-dessus de la tranchée latérale conductrice 41.

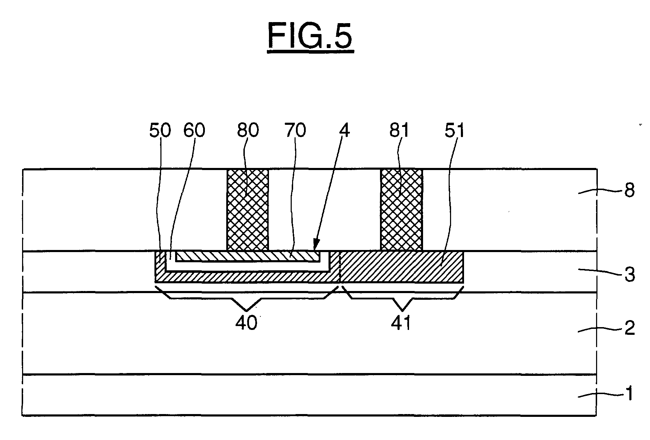

On remplit ces deux cavités par un matériau métallique, ce qui va conduire, après polissage mécano-chimique, à l'obtention de deux plots conducteurs 80 et 81 venant respectivement au contact de l'électrode supérieure 70 du condensateur et de ladite tranchée conductrice 41 (figure 5).

On voit donc sur cette figure 5, que les deux prises de contact du condensateur s'effectuent par le haut, le plot conducteur 81 étant en contact avec l'électrode inférieure du condensateur par l'intermédiaire de la tranchée conductrice 41 remplie du matériau conducteur 51.

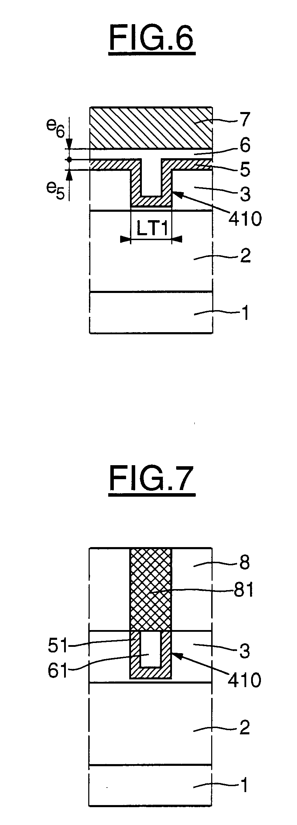

Sur la variante de mise en oeuvre et de réalisation illustrée sur les figures 6 et 7, la largeur LT1 de la tranchée latérale 410 a été choisie par exemple légèrement inférieure au double de la somme e₅ + e₆, ce qui conduit à un remplissage de cette tranchée 410 par le matériau conducteur 5, mais également par le matériau diélectrique 6. Ceci conduit, en final, comme illustré sur la figure 7, à une tranchée 410 comportant uniquement le matériau diélectrique 61 enrobé par le matériau conducteur 51 formant l'électrode inférieure du condensateur.

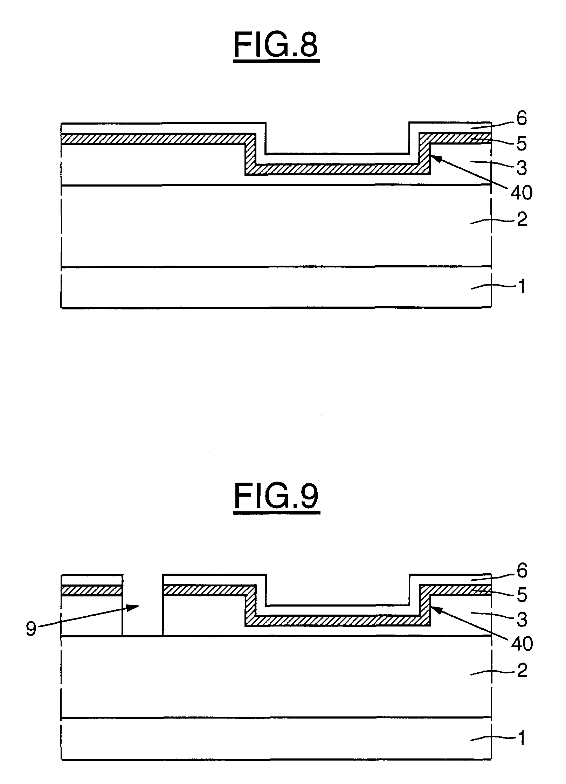

On se réfère maintenant aux figures 8 à 11 pour décrire un exemple de mise en oeuvre du procédé selon l'invention, permettant la réalisation quasi simultanée, d'une piste métallique du niveau de métallisation M2, et de l'élecrode supérieure du condensateur.

A cet égard, comme illustré sur la figure 8, après avoir déposé sur la couche isolante 3, et dans la cavité 4 ménagée dans cette couche 3, l'empilement de la couche 5 et de la couche diélectrique 6, on grave cet ensemble de façon à former au moins une tranchée auxiliaire 9 dans laquelle sera réalisée la future piste métallique du niveau de métallisation M2 (figure 9).

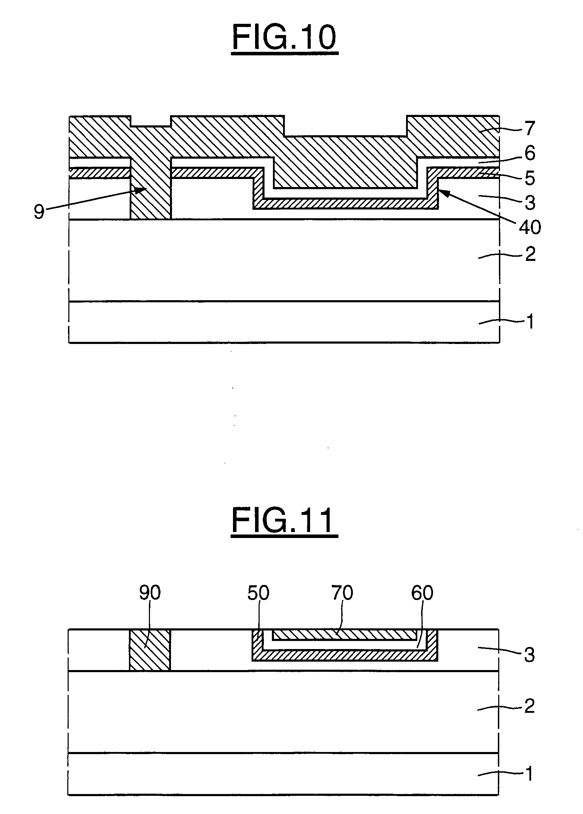

Puis, comme illustré sur la figure 10, on dépose ensuite la deuxième couche conductrice 7 qui remplit simultanément la partie principale 40 de la cavité ainsi que la tranchée auxiliaire 9.

Et, après polissage mécano-chimique de la structure illustrée sur la figure 10, et élimination de la première couche conductrice 5, de la couche diélectrique 6 et de la deuxième couche conductrice 7, de la surface de ladite couche isolante inter-pistes 3, on obtient la structure illustrée sur la figure 11 sur laquelle la référence 90 désigne la piste du niveau de métallisation M2 ainsi formé, simultanément à la formation de l'électrode supérieure 70 du condensateur.

Le reste du procédé s'effectue comme décrit ci-avant, avec éventuellement la réalisation d'un via au-dessus de la piste 90 pour une connexion éventuelle à une piste d'un niveau de métallisation supérieur M3.

## Revendications

1. Procédé de fabrication d'un circuit intégré, comportant la réalisation de plusieurs niveaux de métallisation mutuellement séparés par des couches isolantes inter-niveaux, et de couches isolantes inter-pistes séparant chacune les pistes d'un même niveau de métallisation, ainsi que la réalisation d'au moins un condensateur comportant une électrode inférieure et une électrode supérieure mutuellement séparées par une couche de matériau diélectrique, **caractérisé par le fait que** la réalisation du condensateur comprend :
- la réalisation simultanée, dans au moins une partie d'une couche isolante inter-pistes (3) associée à un niveau de métallisation donné, d'une part des deux électrodes (50, 70) et de la couche diélectrique (60) du condensateur, et d'autre part d'une tranchée conductrice (41) prolongeant latéralement l'électrode inférieure du condensateur, électriquement isolée de l'électrode supérieure, et présentant une dimension transversale plus faible que la dimension transversale du condensateur, et
- la réalisation, dans la couche isolante inter-niveaux (8) recouvrant ladite couche isolante inter-pistes, de deux plots conducteurs (80, 81) venant respectivement au contact de l'électrode supérieure du condensateur et de ladite tranchée conductrice.

2. Procédé selon la revendication 1, **caractérisé par le fait que** la réalisation du condensateur et de la tranchée comporte :
a) la formation sur une couche isolante inter-niveaux (2), de ladite couche isolante inter-pistes (3),
b) la gravure d'au moins une partie de la couche isolante inter-pistes de façon à former une cavité (4) comportant une partie principale (40) prolongée latéralement par ladite tranchée (41),
c) la formation sur la structure obtenue à l'étape b) d'une première couche (5) d'un premier matériau conducteur, la formation sur ladite première couche (5), d'une couche (6) d'un matériau diélectrique, et
d) la formation sur ladite couche diélectrique, d'une deuxième couche (7) d'un deuxième matériau conducteur de façon à remplir la partie principale de ladite cavité, les dimensions de la tranchée et les épaisseurs de la première couche (5) et de la couche diélectrique (6) étant choisies de façon à obtenir à l'issue de l'étape d), une tranchée comportant au moins le premier matériau conducteur et exempte du deuxième matériau conducteur,
e) un polissage mécano-chimique de l'empilement de couches formées aux étapes c) et d) de façon à laisser subsister dans la partie principale de la cavité, ledit condensateur dont l'électrode inférieure est formée d'une partie résiduelle (50) de la première couche tapissant les parois internes de la cavité, et dont l'électrode supérieure est formée d'une partie résiduelle (70) de la deuxième couche, séparée de ladite partie résiduelle de la première couche, par une partie résiduelle (60) de la couche diélectrique, et à laisser subsister dans ladite tranchée (41) une autre partie résiduelle (51) de ladite première couche tapissant au moins les parois internes de la tranchée, à l'exclusion de toute partie résiduelle de ladite deuxième couche.

3. Procédé selon la revendication 2, **caractérisé par le fait que** dans l'étape c), les formations de la première couche conductrice et de la couche diélectrique sont obtenues par un dépôt conforme, et **par le fait que** la largeur de la tranchée (LT) est au moins égale au double de l'épaisseur (e₅) de la première couche conductrice et inférieure au double de la somme de l'épaisseur (e₅) de la première couche conductrice et de l'épaisseur (e₆) de la couche diélectrique.

4. Procédé selon l'une des revendications précédentes, **caractérisé par le fait que** la tranchée (41) ne comporte que le matériau conducteur formant la première électrode.

5. Procédé selon l'une des revendications précédentes, **caractérisé par le fait qu'**on réalise les pistes (90) dudit niveau de métallisation donné simultanément à la formation de l'électrode supérieure du condensateur.

6. Procédé selon les revendications 2 et 5, **caractérisé par le fait que** la réalisation des pistes dudit niveau de métallisation donné comporte
- après l'étape c), une gravure de la couche diélectrique (6), de la première couche conductrice (5) et de la couche isolante inter-pistes (3) de façon à former au moins une tranchée auxiliaire (9),
- le dépôt de ladite deuxième couche conductrice (7) effectué à l'étape d) de façon à remplir ladite ou lesdites tranchées, et
- le polissage mécano-chimique effectué à l'étape e) de façon à éliminer la première couche conductrice, la couche diélectrique et la deuxième couche conductrice de la surface de ladite couche isolante inter-pistes.

7. Circuit intégré, comportant plusieurs niveaux de métallisation mutuellement séparés par des couches isolantes inter-niveaux, et des couches isolantes inter-pistes séparant chacune les pistes d'un même niveau de métallisation,ainsi qu'au moins un condensateur comportant une électrode inférieure et une électrode supérieure mutuellement séparées par une couche de matériau diélectrique, **caractérisé par le fait que** le condensateur est situé dans au moins une partie d'une couche isolante inter-pistes (3) associée à un niveau de métallisation donné, **par le fait que** l'électrode inférieure (50) du condensateur est prolongée latéralement par une tranchée conductrice (41), électriquement isolée de l'électrode supérieure, et présentant une dimension transversale plus faible que la dimension transversale du condensateur, et **par le fait que** le circuit intégré comporte, dans la couche isolante inter-niveaux recouvrant ladite couche isolante inter-pistes, deux plots conducteurs venant respectivement au contact de l'électrode supérieure du condensateur et de ladite tranchée conductrice.

8. Circuit intégré selon la revendication 7, **caractérisé par le fait que** la tranchée (41) comporte uniquement le matériau conducteur formant ladite électrode inférieure.

9. Circuit intégré selon la revendication 7, **caractérisé par le fait que** la tranchée (410) comporte uniquement le matériau diélectrique enrobé par le matériau conducteur formant ladite électrode inférieure.

10. Circuit intégré selon l'une des revendications 7 à 10, **caractérisé par le fait que** les pistes (90) dudit niveau de métallisation donné sont formées du même matériau que celui formant l'électrode supérieure du condensateur.
